(19) Europäisches Patentamt
European Patent Office
Office européen des brevets

(11) EP 0 328 350 B1

(12) EUROPEAN PATENT SPECIFICATION

(45) Date of publication and mention of the grant of the patent:
**28.04.1999 Bulletin 1999/17**

(51) Int Cl.[6]: **H01L 21/31**, C23F 1/12

(21) Application number: **89301177.5**

(22) Date of filing: **08.02.1989**

(54) **Dry etching with hydrogen bromide or bromine**

Trockenätzen mit Wasserstoffbromid oder Brom

Attaque sèche avec du bromure d'hydrogène ou du brome

(84) Designated Contracting States:
**DE FR GB**

(30) Priority: **09.02.1988 JP 26654/88**
**19.07.1988 JP 178244/88**
**28.09.1988 JP 240940/88**
**15.11.1988 JP 286880/88**

(43) Date of publication of application:
**16.08.1989 Bulletin 1989/33**

(73) Proprietor: **FUJITSU LIMITED**
**Kawasaki-shi, Kanagawa 211 (JP)**

(72) Inventors:
- **Nakamura, Moritaka**
  **Yokohama-shi, Kanagawa 227 (JP)**
- **Kurimoto, Takashi**
  **Hashima-shi, Gifu 501-62 (JP)**
- **Iizuka, Katsuhiko**
  **Kawasaki-shi, Kanagawa 213 (JP)**

(74) Representative: **Silverman, Warren et al**
**Haseltine Lake & Co.**
**Imperial House,**
**15-19 Kingsway**
**London WC2B 6UD (GB)**

(56) References cited:

| | |
|---|---|
| EP-A- 250 092 | EP-A- 272 143 |
| EP-A- 289 131 | US-A- 4 419 201 |
| US-A- 4 490 209 | US-A- 4 744 861 |

- **J. VAC. SCI. TECHNOL., Vol. B6, No. 1; January/February 1988, pages 72-76, American Vacuum Soc., A. LANDAUER et al.: "Temperature and flow effects in aluminum etching using bromine-containing plasmas"**
- **APPLIED PHYSICS LETTERS, Vol. 52, No. 8, February 22, 1988, pages 616-618, American Inst. of Physics, New York, US; S. TACHI et al.: "Low-temperature reactive ion etching and microwave plasma etching of silicon"**
- **J. VAC. SCI. TECHNOL., Vol. B6, No. 1, January/February 1988, pages 257-262, Am. Vac. Inst., Woodbury, US; A.M. EL-MASRY et al.: "Magnetically enhanced reactive ion etching of silicon in bromine plasmas"**
- **EXTENDED ABSTRACTS, Electrochem. Soc., Vol. 87-2, October 1987, pages 1038-1039, Princeton, N.J., US; H. UCHIDA et al.: "Submicron trench etching under high pressure (60 Pa)"**
- **EXTENDED ABSTRACTS OF THE 20th CONFERENCE ON SOLID STATE DEVICES AND MATERIALS; August 24-26, 1988, Tokyo, JP, pages 549-552, Jap. Soc. of Applied Physics; H. OKANO et al.: "Down-flow process in VLSI manufacturing"**
- **PATENT ABSTRACTS OF JAPAN Vol. 10, No. 125 (E-402) May 10, 1986 & JP-A-60 257 539 (HITACHI MAIKURO COMPUTER ENGINEER) 19-12-1985**

Note: Within nine months from the publication of the mention of the grant of the European patent, any person may give notice to the European Patent Office of opposition to the European patent granted. Notice of opposition shall be filed in a written reasoned statement. It shall not be deemed to have been filed until the opposition fee has been paid. (Art. 99(1) European Patent Convention).

EP 0 328 350 B1

## Description

The present invention relates to dry etching a material such as polycrystalline silicon with hydrogen bromide or bromine.

As a result of the increased degree of integration and switching speed of IC's, an insulating film such as a gate insulating film must be made thinner, for example, 30 nm to 50 nm, and further, a multilayer technology for electrical conductive materials such as polycrystalline silicon must be utilized. This processing of such a polycrystalline silicon determines a gate length, which influences the characteristics of an FET, and thus, during etching of the polycrystalline silicon, the width of a pattern must be strictly controlled and there must be high etching selectivity of the polycrystalline silicon obtained in relation to an underlying gate insulating layer. To accomplish the above, vertical etching methods, such as reactive ion etching, can be used, but if a lower layer, for example, a first polycrystalline silicon layer, is vertically etched, the thickness of an upper layer, for example, a second polycrystalline silicon layer, becomes thicker at a portion of a step of the vertically etched first polycrystalline silicon layer than at the other flat portion. This thicker portion of the second polycrystalline silicon layer remains after the second polycrystalline silicon layer is etched, and leads to a short circuiting of adjacent patterns of the second polycrystallino silicon layer through the remaining portion. If the second polycrystalline silicon layer is over-etched for an extended time, to completely remove the polycrystalline silicon at the step portion, the width of a pattern is narrowed and the underlying insulating layer is excessively etched.

One solution to the above problems is the use of a vertical etching process having a high selectivity, so that an underlying layer is not excessively etched. To obtain this high selectivity, a chlorine-bearing or fluorine-bearing etching gas is widely used, but etching with a chlorine or fluorine-bearing gas tends to cause side-etching, due to the isotropic nature thereof, and it becomes difficult to control the width of a pattern. To protect the side wall of a pattern from such an etching gas, a carbon-bearing gas may be used, but use of a carbon-bearing gas increases the etching rate of an insulating layer, whereby the selectivity of etching of a polycrystalline silicon, etc. in relation to an insulating layer is reduced. Further, a polymer containing carbon is deposited onto a wall of an etching chamber, which causes contamination and a reduction of the product yield.

Another solution is to form a pattern of a first polycrystalline silicon layer having a tapered shape, i.e., a declined, not vertical, side wall, on which a second polycrystalline silicon layer is deposited and then etched.

The known methods of taper etching are as follows:

(1) Phosphorus is diffused and phosphorus ions are then implanted to a first polycrystalline silicon layer, to make the ion implanted surface portion of the layer more receptive to etching. Then isotropic etching is carried out on the polycrystalline silicon layer, and thus the polycrystalline silicon layer is taper etched. [Japanese Unexamined Patent Publication Nos. 58-4932 and 53-73086 and Japanese Examined Patent Publication No. 60-782] Nevertheless, this process is complicated, since a diffusion of phosphorus and ion implantation is necessary before the etching. Also, it is difficult to control a width of a pattern during isotropic etching.

(2) Etching with an etching gas to which a depositing gas such as $C_2H_6$ , $C_2H_4$ , is added to provide a simultaneous etching and deposition to form a tapered pattern. [Japanese Unexamined Patent Publication Nos. 59-103338, 62-30330 and 62-32618] This method allows a deposition on on a wall of an etching chamber, which results in contamination by particles and reduces the product yield.

(3) A resist mask is tapered and etching is effected with a low etching selectivity between polycrystalline silicon and the resist. [Japanese Unexamined Patent Publication (Kokai) No. 61-61424] In this method, since the thickness of the resist is varied, it is difficult to control the width of a pattern.

(4) Alternate etching and ashing of a resist mask. [Japanese Unexamined Patent Publication (Kokai) No. 56-93319 and 57-59331] This process is complicated and control of the width of a pattern is difficult, since the thickness of the resist mask is reduced.

(5) Isotropic etching followed by anisotropic etching. The isotropic etching is stopped when only an upper part of a polycrystalline silicon layer is etched, and then the anisotropic etching is carried out. [Japanese Unexamined Patent Publication No. 57-7936 and 56-90525] This process also is complicated, and the control of the width of a pattern is difficult.

(6) A mask having an overhanging portion having a lower surface facing upward is used, so that the flow of ions is disturbed and thus a tapered pattern is formed. [Japanese Examined Patent Publication No. 57-42154] It is not easy, however, to form a resist mask having an overhanging portion as above, and it is difficult to control the width of an etched pattern.

According to the present invention high selectivity of etch is achieved in a process for selectively etching a mass of silicon, comprising: providing an etching mask over the mass, defining exposed areas of the mass that are to be etched; and providing a plasma of an etching gas in contact with the exposed areas of said mass in an etching chamber; characterised in that said etching chamber has no carbon-containing material in contact with said,plasma of

the etching gas and in that said etching gas contains hydrogen bromide, bromine or a combination thereof as a main reactive component that reacts with said mass and has a carbon content of less than 120 ppm of carbon based on the total weight of said etching gas.

In one process embodying this invention, to achieve in the etched mass of silicon a sidewall having an inclination of less than 90°C, it should be ensured that the etching gas does not include any carbon-containing component and that etching is carried out at a temperature of from -40°C to +50°C.

As described above, a carbon-bearing gas may cause deposition of a polymer onto a wall of an etching chamber, which may result in contamination by particles in products. Further, a carbon-bearing etching gas may reduce the etching selectivity of materials such as polycrystalline silicon. Accordingly, any carbon content of the etching gas used in a process of the present invention is less than 120 ppm, preferably less than 40 ppm, based on the total weight of the etching gas. Ideally, the carbon content of the etching gas should be zero. Similarly, the etching chamber does not include a carbon-bearing material which can come into contact with a plasma of an etching gas. Such a carbon-bearing material could disadvantageously reduce the etching selectivity of a material to be etched.

In a preferred embodiment of the invention, to etch selectively said exposed area of said mass to form said mass with an etched portion and a side wall along a periphery of said etching mask having a predetermined angle of inclination, a temperature is imparted to said mass during said etching which is set to give the etched mass side wall the predetermined angle of inclination.

Japanese Examined Patent Publication No.58-14507, corresponding to U.S. patent application S.N. 594418, filed on July 9, 1975, suggests that bromine or a bromine compound may be used for a vertical etching of silicon, but in this publication, only carbon tetrachloride is actually used in experiments, and bromine or a bromine compound is mentioned merely as a possible alternative. Furthermore, this publication states that a target electrode must be heated, since the boiling point of SiBr, at which it is thought to be vaporized, is 153°C. The present inventors, however, surprisingly found that a vertical etching of silicon, etc., can be carried out at a temperature lower than 150°C, and further, that a taper etching can be obtained at a temperature of -40°C to 50°C, in which process the taper angle of the etching is precisely controlled in accordance with the temperature.

U.S. Patent No. 4,490,209 issued on December 25, 1984 to Hartman discloses a plasma etching which allows an anisotropic etching of silicon, in which a gaseous mixture of a chlorine-bearing species and hydrogen bromide is used. In this patent, however, a chlorine-bearing species must be used as a main reactive component and hydrogen bromide added in a small amount of about 1 to about 10%, to allow a near perfect anisotropic etching. This process is different from the process of the present invention, in which hydrogen bromide or bromine is used as a main etching or reactive component and not only a vertical etching but also a taper etching can be carried out, and the taper angle controlled as desired.

Therefore, in an embodiment of the present invention, a taper etching having an inclination angle of the side wall of an etched mass of less than 90° is obtained at a temperature of the mass etched of -40°C to +50°C, and a substantially vertical etching is carried out at a temperature of the etched mass of 50°C to 150°C. The relationship between the angle of inclination of the side wall of the mass etched and the temperature of the mass etched is expressed as follows:

$$\theta \doteqdot \frac{t}{2} + 65$$

where θ stands for the inclination angle of the side wall of the etched mass and t stands for the temperature of the mass during etching, the inclination angle θ having a dispersion of ±5°. Note, the temperature mentioned above is that of the mass to be etched, not that of an atmosphere surrounding the mass to be etched. Furthermore, for a p-type or non-doped polycrystalline silicon, at a temperature of an etched mass of more than 150°C, a taper etching having an inclination angle of the side wall of the etched mass of more than 90° can be obtained. For an n-type polycrystalline silicon, at a temperature of more them 150°C, side etching or undercut profile is obtained.

For a better understanding of the invention and to show how the same can be carried into effect, reference will now be made, by way of example only to the accompanying drawings, wherein:

Figures 1A to 1C show the main steps of dry etching an upper layer of polycrystalline silicon on a lower layer of polycrystalline silicon as effected conventionally;
Fig. 2 is a perspective view showing an etching residue resulting from dry etching as shown in Figs. 1A to 1C;
Fig. 3 is a schematical view of an apparatus for plasma etching used in a process according to the present invention;
Figs. 4A to 4E are sectional views of patterns etched in accordance with a process of the present invention;
Fig. 5 shows relationships of the taper angle obtainable by the dry etching and the temperature of a wafer during

etching;

Fig. 6 is a schematical view of an apparatus for plasma etching used in an embodiment of the present invention; and

Fig. 7 shows the relationship of the etching selectivity of polycrystalline silicon to $SiO_2$ and the carbon content in etching gas.

Before describing an embodiment of the present invention in detail, the prior art is briefly illustrated using drawings.

Figures 1A to 1C illustrate the steps of an RIE of an upper polycrystalline silicon layer on a step portion of a lower polycrystalline silicon layer. In Fig. 1A, 1 denotes a silicon substrate, 2 an insulating film, 3 a first polycrystalline silicon layer, 4 an insulating film, and 5 a second polycrystalline silicon layer deposited by CVD. The second layer 5 has different thickness A and B over flat and step portions of the first layer 3; the thickness B of the second layer over the step portion is larger than the thickness A over the flat portion. When this structure is subject to RIE, a portion 7 of the second polycrystalline silicon layer near the step portion of the first polycrystalline silicon layer 3 remains unetched, as seen in Fig. 1B. This remaining portion 7 may cause a short circuit between adjacent wiring patterns of the second polycrystalline silicon layer, as seen in Fig. 2. If the second polycrystalline silicon layer 5 is subject to overetching, to completely remove the portion 7, the insulating films 2 and 4 are undesirably excessively etched as seen in Fig. 1C. This is because of a relatively low selectivity of etching between the polycrystalline silicon and the insulating films.

An embodiment of the present invention is now described in more detail.

Figure 3 shows a reactive ion etching (RIE) apparatus used in the following example. In this apparatus, a wafer 11 is electrostatically mounted to an electrostatic chuck 12 by applying a voltage of ±1500 V to the chuck 12 through low pass filters 13, from a DC power source 14. A gas, for example, helium under a pressure of 0 - 20 Torr (1 Torr = 133.3 Pa), is introduced between the wafer and the chuck 12, through a gas inlet 21 from a pressure-adjusting unit (not shown), to facilitate thermal conduction. The temperature of the electrode 15 is controlled by cooling water 16. When the electrode 15 is to be cooled to less than 0°C, the cooling liquid is composed of methanol, a mixture of water and ethylene glycol, or a mixture of water and methanol. An etching chamber 22 is evacuated through an exhaust port 20 by a vacuum pump (not shown). An etching gas is introduced to the chamber 22 through a gas introducing port 19, and a high frequency wave is applied to the gas by an RF generator 18 through a matching box 17, to generate a plasma and thereby carry out an etching.

The temperature of the wafer 11 during etching is detected by a fluorescent thermometer 24. A fluorescent material 26 is applied on a rear side surface of the wafer 11, and a pulse light is irradiated to the fluorescent material 26 through a glass fiber 23 passing through a pore 25 of the electrode 15, and a fluorescent light generated from the fluorescent material 26 is observed through the same glass fiber 23 to determine the temperature of the wafer 11. The fluorescent thermometer 24 used is the LUXTRON 750 marketed by LUXTRON (1060 Terra Bella Avenve, Mountain View, CA 94043, U.S.A.). This thermometer can advantageously precisely determine the wafer temperature without interference by noise from the RF, since it uses a glass fiber unlike a conventional thermocouple which cannot block the noise from the RF. This precise determination, of the wafer temperature is essential to the preferred embodiment of the present invention.

The temperature of a wafer depends on the etching gas, pressure, RF power, etc., but can be controlled, even when these conditions are fixed, by changing the temperature of the cooling liquid 16 to change the temperature of the electrode 15, by changing the kind or pressure of the gas such as He introduced between the wafer 11 and the electrostatic chuck 12, or by changing the voltage applied to the chuck 12 to change the force attracting the wafer 11, to change the thermal conduction between the wafer 11 and the electrode 15.

Figures 4A to 4D show cross sections of a phosphorus-doped n-type polycrystalline silicon (resistance 60 $\Omega/cm^2$ pattern etched in accordance with the present invention and using an apparatus shown in Fig. 3. In Figs. 4A and 4B, reference numeral 38 denotes a mask of a photoresist, $SiO_2$ , $Si_3N_4$ , etc., 33 denotes a polycrystalline silicon layer to be etched, 32 denotes an underlying insulating film of $SiO_2$ , etc., and 31 denotes a silicon substrate. The etching conditions are as follows: a gas of $Br_2$ (16 SCCM) + He (57 SCCM), a pressure of 0.1 Torr, a power of 300 W, and 100% overetching after etching the polycrystalline silicon layer 33. Figure 4A shows a pattern etched at 80°C; Fig. 4B a pattern etched at 0°C; and Fig. 4C a pattern etched at 160°C; and Fig. 4D a pattern etched at 200°C. In these figures the angle of inclination of a side wall 39 of the etched pattern 33 is designated by the mark θ. The angle θ is about 90° in Fig. 4A, about 60° in Fig. 4B. As seen in these figures, varied etching shapes are obtainable by changing only the temperature of a wafer.

Figure 5 shows the relationship between the inclination angle θ of an etched polycrystalline silicon and a temperature of the wafer, in which n-type doped and non-doped polycrystalline silicons are etched with a mask of a photoresist or $SiO_2$. In Fig. 5, the black triangles represent an n-type doped polycrystalline silicon etched with a photoresist mask; the black circles represent an n-type doped polycrystalline silicon etched with an $SiO_2$ mask; the white triangles represent a non-doped polycrystalline silicon etched with a photoresist mask; and, the white circles represent a non-doped polycrystalline silicon etched with an $SiO_2$ mask. As seen in Fig. 5, an angle of inclination of an etched

pattern of less than 90° is obtained at a wafer'temperature of -40° to +50° and the inclination angle is increased with an increase of the wafer temperature in the above temperature range. This relationship is represented by the formula: $\theta = t/2 + 65 \pm 5$, i.e., $t/2 + 60 \leqq \theta \leqq t/2 + 70$, wherein t stands for the wafer temperature. At a wafer temperature of 50°C to 150°C, the polycrystalline silicons are etched substantially vertically, i.e., the inclination angle θ is about 90°. At a wafer temperature of more than 150°C, for a non-doped polycrystalline silicon, the inclination angle θ of the etched polycrystalline silicons may be more than 90° as shown in Fig. 4E. Note that, at a wafer temperature of more than about 150°C, the photoresist may be burnt and special heat treatment such as deep UV cure is required. Accordingly, a desired inclination angle θ of an etched polycrystalline silicon pattern can be obtained by changing the wafer temperature. At a wafer temperature of less than -40°C, an appropriate etching cannot be carried out and needle-like residues remain.

In the Examples which follow, Examples 15 to 32 serve to establish the principle underlying the present invention. The principle of the preferred embodiment wherein temperature selection is used to control side wall inclination is established in Example 18 and discussed more fully in Examples 1 to 14.

Example 1

An $SiO_2$ layer having a thickness of 20 nm, on which a phosphorus-doped polycrystalline silicon layer (resistance 20 $\Omega/cm^2$) was deposited to a thickness of 400 nm, was thermally grown on the surface of a silicon substrate. A photoresist pattern was formed on the phosphorus-doped polycrystalline silicon layer by a usual photolithography technique. The substrate or wafer was mounted in the apparatus as shown in Fig. 3, and an RIE was carried out under a supply of an etching gas of 16 SCCM - $Br_2$ + 57 SCCM - He, a pressure of 0.1 Torr, a power of 300 W, He supplied between the wafer and the electrostatical chuck at 10 Torr, a cooling liquid temperature of -15°C, and an electrode temperature of -10°C. The maximum wafer temperature was 0°C.

The results are shown in the following Table 1. The width of the etched polycrystalline silicon pattern was the same as that of the mask.

Example 2

The procedures of Example 1 were repeated except that the cooling liquid temperature was 25°C, the electrode temperature was 25°C, and the He pressure was 2 Torr. The maximum wafer temperature was 50°C.

The results are shown in Table 1.

Example 3

A phosphorus-doped polycrystalline silicon layer was deposited, and a CVD $SiO_2$ layer having a thickness of 100 nm was grown thereon and patterned by a usual photolithography technique using RIE with photoresist. After removing the photoresist, the procedures of Example 1 were repeated.

The results are shown in Table 1.

Example 4

A sample prepared in accordance with the procedures of Example 3 was etched under the same conditions as in Example 2, followed by an overetching of the polycrystalline silicon for the same time as required for the former etching.

The results are shown in Table 1.

Example 5

The same sample as in Example 1 was etched under a supply of an etching gas of 25 SCCM - HBr + 57 SCCM - He, a pressure of 0.12 Torr, a power of 350 W, He supplied between the wafer and the chuck at 10 Torr, a cooling liquid temperature of -15°C, and an electrode temperature of -10°C. The maximum wafer temperature was 5°C.

The results are shown in Table 1.

Example 6

As in Example 5, etching was carried out under a cooling liquid temperature of 20°C, an electrode temperature of 20°C, and an He pressure of 2 Torr. The maximum wafer temperature was 50°C. Overetching was carried out for the same time as required for the former etching.

The results are shown in Table 1.

Table 1

| Ex. | Mask | Wafer temp. (°C) | Etching1) rate (nm/min) | Etching2) selectivity | Etching inclination angle θ |
|---|---|---|---|---|---|
| 1 | Resist | 0 | 150 | 10 | 57° |
| 2 | Resist | 50 | 200 | 23 | 82°* |
| 3 | $SiO_2$ | 0 | 150 | 30 | 62° |
| 4 | $SiO_2$ | 50 | 200 | 50 | 89°* |
| 5 | Resist | 5 | 100 | 15 | 62° |
| 6 | Resist | 50 | 170 | 27 | 92° |

1) Etching rate is that of the polycrystalline silicon

2) Etching selectivity is that of polycrystalline silicon to $SiO_2$.

*) The angles 82°, 89° and 92° are considered substantially vertical.

Examples 7 - 14

A sample prepared as in Example 3 was etched under a supply of an etching gas of 50 SCCM - HBr, a pressure of 0.1 Torr, a power of 300 W (a power density of 0.66 W/cm$^2$), and He supplied between the wafer and the chuck at 10 Torr. The electrode temperature was controlled by heating with a heater arranged in the electrode, to within 80°C to 300°C.

The results are shown in Table 2.

Table 2

| Ex. | Mask | Wafer temp. (°C) | Etching rate (nm/min) | Etching selectivity | Etching inclination angle θ |
|---|---|---|---|---|---|
| 7 | $SiO_2$ | 80°C | 300 | 30 | vertical (90°) |
| 8 | $SiO_2$ | 100°C | 310 | 31 | vertical (90°) |
| 9 | $SiO_2$ | 130°C | 320 | 32 | vertical (90°) |
| 10 | $SiO_2$ | 150°C | 330 | 33 | vertical (90°) |
| 11 | $SiO_2$ | 160°C | 320 | 32 | slightly undercut (as in Fig. 4C) |
| 12 | $SiO_2$ | 180°C | 310 | 26 | undercut (as in Fig. 4D) |
| 13 | $SiO_2$ | 200°C | 300 | 21 | undercut (as in Fig. 4D) |
| 14 | $SiO_2$ | 300°C | 240 | 13 | undercut (as in Fig. 4D) |

Example 15

Figure 6 shows a parallel plan-type apparatus for RIE used in these Examples, in which 41 denotes a wafer, 42 an etching chamber, 43 an upper electrode, 44 a lower electrode, 45 an electrostatic chuck, 46 a block of quartz glass for holding a wafer, 47 a DC power source for electrostatic attraction of a wafer, 48 a high frequency power, 49 a gas inlet, and 50 a gas outlet. The wafer temperature was determined by a fluorescent thermometer, not shown. The walls of the etching chamber 42 and the surface of the upper electrode 42 are covered with quartz glass or a material that does not contain carbon.

A sample for etching was prepared as follows: On a silicon substrate or wafer, an $SiO_2$ film having a thickness of 100 nm was thermally grown, on which a polycrystalline silicon layer having a thickness of about 400 nm was deposited, on which, in turn, a mask pattern of $SiO_2$ or $Si_3N_4$ having a thickness of about 200 nm and a width of 1 $\mu$m was deposited.

The above sample was held by the holder 46 or by the electrostatic chuck 45, and the sample was subject to RIE to selectively etch the polycrystalline silicon. The etching gas was HBr and was introduced at 50 SCCM from the gas inlet 49 into the etching chamber 42 and evacuated through the gas outlet 50 to keep a pressure inside the chamber 42 at 0.1 Torr, and to which a high frequency (13.56 MHz) power of 300 W was applied by the power source 48. Accordingly, the RIE was carried out while varying the wafer temperature, and as a result, a vertical etching was attained at a wafer temperature of 50°C to 150°C. The etching rate of the polycrystalline silicon was 220 nm/min and that of the $SiO_2$ was 2 nm/min, and thus the obtained etching selectivity of the polycrystalline silicon to the $SiO_2$ was as high as 110, and was repeatable.

The results are shown in Table 3.

Example 16

The procedures of Example 15 were repeated except that the flow rate of HBr was increased. This increase of the flow rate of HBr, increased the etching rate of the polycrystalline silicon. At an HBr flow rate of 100 SCCM, the polycrystalline silicon etching rate was about 290 nm/min, while the etching selectivity of the polycrystalline silicon to the $SiO_2$ was 82.

The results are shown in Table 3.

Example 17

The procedures of Example 15 were repeated except that oxygen ($O_2$) or water ($H_2O$), bearing an oxygen atom but no carbon atom, was added to the HBr etching gas. As a result, the etching rate of the polycrystalline silicon was not changed (220 nm/min), but the etching rate of the $SiO_2$ was lowered to 1 nm/min, and therefore, the etching selectivity of the polycrystalline silicon to the $SiO_2$ was higher than 200.

The results are shown in Table 3.

Table 3

| Ex. | Etching gas | Mask | Temp. for vertical etching (°C) | Etch rate of Poly-Si (nm/min) | Etch rate of $SiO_2$ (nm/min) | Selectivity of Poly-Si/$SiO_2$ |
|---|---|---|---|---|---|---|
| 15 | HBr 25 SCCM | $SiO_2$ (or $Si_3N_4$) | 50 - 150 | 220 | 2 | 110 |
| 16 | HBr 100 SCCM | $SiO_2$ (or $Si_3N_4$) | 50 - 150 | 290 | 3.5 | 82 |
| 17 | HBr +O2 | $SiO_2$ (or $Si_3N_4$) | 50 - 150 | 220 | 1 | 220 |

Example 18

In Examples 15 to 17, vertical etching was attained at a temperature of the wafer of 50°C to 150°C. When the temperature of the wafer was lowered to less than 50°C, taper etching was attained with an inclination angle θ of the side wall of the etched pattern of less than 90°.

Example 19

The procedures of Examples 15 to 18 were repeated, except that the etching chamber was made of aluminum coated with a polytetrafluoroethylene film.

The results are shown in Table 4.

Table 4

| Ex. | Etching gas | Mask | Temp. for vertical etching(°C) | Etch rate of Poly-Si (nm/min) | Etch rate of $SiO_2$ (nm/min) | Selectivity of Poly-Si/$SiO_2$ |
|---|---|---|---|---|---|---|
| 19 | HBr | Resist | 50 - 90 | 220 | 15 | 15 |
| 20 | HBr | $SiO_2$ | 50 - 150 | 220 | 7 | 31 |
| 21 | HBr | $Si_3N_4$ | 50 - 150 | 220 | 7 | 31 |
| 22 | HBr/$O_2$ | $SiO_2$ | 50 - 150 | 220 | 5 | 44 |

As seen in Table 4, by using a chamber having a coating of a carbon-bearing material, the etching rate of the polycrystalline silicon was not changed, but the $SiO_2$ etching rate was increased, and thus the etching selectivity of the polycrystalline silicon to $SiO_2$ was decreased.

When other carbon-bearing materials such as polyacetal resin, carbon, silicon carbide etc. were used in the chamber or on the electrode, the $SiO_2$ etching rate was increased and the etching selectivity was decreased.

Examples 23 to 28

The procedures of Examples 15 to 22 were repeated except that the etching gas was changed from HBr to other gases.
The results are shown in Table 5. The results were not varied, regardless of the material of the etching chamber.
Note, that, although etching with $SF_6$ at -130°C provided an excellent etching rate and etching selectivity, etching at a low temperature of -130°C requires a cooling mechanism using liquid nitrogen, etc., making the apparatus complicated, less reliable, and expensive.

Table 5

| Ex. | Etching gas | Mask | Temp. for vertical etching (°C) | Etch rate of Poly-Si (nm/min) | Etch rate of $SiO_2$ (nm/min) | Selectivity of Poly-Si/$SiO_2$ |
|---|---|---|---|---|---|---|
| 23 | $SF_6$ | $SiO_2$ | -130 or less | 600 | 6 | 100 |
| 24 | $CCl_4$ | Resist | 50 - 100 | 400 | 80 | 5 |
| 25 | $Cl_2$ | Resist | 0 or less | 420 | 40 | 11 |
| 26 | $Cl_2$ | $SiO_2$ | -50 or less | 400 | 16 | 25 |
| 27 | $Br_2$/He | Resist | 50 - 70 | 190 | 14 | 14 |
| 28 | $Br_2$/He | $SiO_2$ | 50 - 70 | 190 | 9.5 | 20 |

Example 29

The procedures of Example 15 were repeated, except that the HBr used had a purity of 99.99% and a carbon content of 30 ppm by volume based on $CO_2$.
The results are shown in Table 6.

Example 30

The procedures of Example 29 were repeated, except that the HBr used had a purity of 99.8% and a carbon content of 350 ppm by volume based on $CO_2$.
The results are shown in Table 6.
The etching of the polycrystalline silicon per se was not affected, but the $SiO_2$ etching rate of was increased so that the etching selectivity of the polycrystalline silicon to the $SiO_2$ was reduced to 31.

Table 6

| Ex. | Etching gas | Mask | Temp. for vertical etching (°C) | Etch rate of Poly-Si (nm/min) | Etch rate of $SiO_2$ (nm/min) | Selectivity of Poly-Si/$SiO_2$ |
|---|---|---|---|---|---|---|
| 29 | HBr 25 SCCM (high purity) | $SiO_2$ | 50 - 150 | 220 | 2 | 110 |
| | | $Si_3N_4$ | 50 - 150 | 220 | 2 | 110 |
| 30 | HBr 25 SCCM (low purity) | $SiO_2$ | 50 - 150 | 220 | 7 | 31 |
| | | $Si_3N_4$ | 50 - 150 | 220 | 7 | 31 |

Example 31

The procedures of Example 29 were repeated except that the etching gases used were 50 SCCM of the 99.99% HBr having a carbon content of 30 ppm (by volume as $CO_2$), mixed with 5 SCCM of a mixture of argon containing

3000 ppm by volume of $CH_4$ or $CO_2$ and a high purity argon containing no carbon at a various ratio. Namely, the HBr etching gas used had a varied carbon content.

The etching of the polycrystalline silicon was not changed by mixing the carbon content of the HBr, but the etching rate of the $SiO_2$ was increased when the carbon content was increased, and the etching selectivity of the polycrystalline silicon to the $SiO_2$ was decreased. Namely, selectivity was 100 at a 40 ppm carbon content and 60 at a 120 ppm carbon content. These results are shown in Fig. 7.

Example 32

Three kinds of samples were prepared for the following Examples.

Sample A: On a silicon wafer, a thermally oxidized film having a thickness of 10 nm was grown, on which a polycrystalline silicon layer having a thickness of 200 nm was deposited by CVD. Into the polycrystalline silicon layer, arsenic ions were implanted at 70 keV and $4 \times 10^{15}$ /cm$^2$. On the As-doped polycrystalline silicon layer, a positive-type photoresist layer having a thickness of 1.2 μm was coated and patterned to a minimum width of 0.6 μm.

Sample B: This sample was similar to sample A, but As was not the ion implanted. Phosphorus was thermally diffused into the polycrystalline silicon to obtain a resistance of 60 Ω/cm$^2$.

Sample C: A thermally oxidized film having a thickness of 400 nm was grown on a silicon wafer. A resist pattern was formed on the oxidized film, in the same manner as for sample A.

The etching apparatus used was similar to that shown in Fig. 6. The etching conditions were: an HBr etching gas at 120 SCCM, and a wafer temperature of 20°C to 150°C. The etching of the samples A and B was stopped before the polycrystalline silicon layer was completely removed and the etching rates of As-doped and P-doped polycrystalline silicons were determined.

The sample C was etched for 5 minutes and the etching rate of the oxidized film and the etching selectivity of the polycrystalline silicon to the oxidized film were determined.

The results are shown in Table 7.

**Table 7**

| Ex. | Etching gas | Mask | Wafer Temp. (°C) | Etch rate of As-doped Poly-Si (nm/min) | Etch rate of P-doped Poly-Si (nm/min) | Etch rate of $SiO_2$ (nm/min) | Selectivity of P-doped Poly-Si/$SiO_2$ |
|---|---|---|---|---|---|---|---|
| 32 | HBr | Resist | 20 | 170 | 220 | 14 | 16 |
| | HBr | Resist | 50 | 190 | 240 | 14 | 17 |
| | HBr | Resist | 100 | 220 | 270 | 14 | 19 |
| | HBr | Resist | 150 | 260 | 300 | 14 | 21 |

## Claims

1. A process for selectively etching a mass of silicon, comprising:

providing over the mass an etching mask defining exposed areas of the mass that are to be etched; and providing a plasma of an etching gas in contact with the exposed areas of said mass in an etching chamber;

characterized in that said etching chamber has no carbon-containing material in contact with said plasma of the etching gas and that said etching gas contains hydrogen bromide, bromine or a combination thereof as a main reactive component that reacts with said mass and has a carbon content of less than 120 ppm of carbon based on the total weight of said etching gas.

**2.** A process as claimed in claim 1, wherein said etching gas does not include any carbon-containing component and etching is carried out at a temperature of from -40°C to +50°C.

**3.** A process as claimed in claim 2, wherein, in order to cause an etched side wall portion of the mass to have an angle of inclination $\theta \pm 5°$, the said mass is maintained during said etching at a temperature chosen in accordance with the following formula:

$$\theta = \frac{t}{2} + 65$$

where t is the temperature of the mass in degrees Celsius.

**4.** A process as claimed in claim 1, 2 or 3, wherein said mass is made of a polycrystalline silicon.

**5.** A process as claimed in any preceding claim, wherein said etching mask is composed of a non-carbon-containing material.

**6.** A process as claimed in claim 4, wherein said etching mask is made of silicon oxide or nitride.

**7.** A process as claimed in claim 1 or claim 3, 4, 5 or 6, when not appended to claim 2, wherein said etching gas has a carbon content of less than 40 ppm of carbon based on the total weight of said etching gas.

**8.** A process as claimed in claim 1, wherein said etching gas does not contain any carbon-containing compound and the said mass is formed of p-type silicon or undoped silicon and is maintained at a temperature greater than +150°C during said etching to cause an etched side wall portion of the mass, along a periphery of said etching mask, to have an angle of inclination ($\theta$) greater than 90°.

**9.** A process as claimed in claim 3 or any one of claims 4 to 8 when appended to claim 3, wherein said etching gas contains only hydrogen bromide as the reactive component and further contains an inert gas.

**10.** A process as claimed in claim 3 or any one of claims 4 to 8 when appended to claim 3, wherein said etching gas contains only bromine as the reactive component and further contains an inert gas.

**Patentansprüche**

**1.** Prozeß zum selektiven Ätzen einer Siliziummasse, der die folgenden Schritte umfaßt:

Vorsehen einer Ätzmaske über der Masse, die exponierte Bereiche der Masse definiert, die zu ätzen sind; und Vorsehen eines Plasmas aus einem Ätzgas in Kontakt mit den exponierten Bereichen der Masse in einer Ätzkammer;

dadurch gekennzeichnet, daß die Ätzkammer kein kohlenstoffhaltiges Material hat, das mit dem Plasma aus dem Ätzgas in Kontakt gelangt, und daß das Ätzgas Bromwasserstoff, Brom oder eine Kombination daraus als Hauptreaktionskomponente enthält, die mit der Masse reagiert, und einen Kohlenstoffgehalt von unter 120 ppm Kohlenstoff auf der Basis des Gesamtgewichtes des Ätzgases hat.

**2.** Prozeß nach Anspruch 1, bei dem das Ätzgas keine kohlenstoffhaltige Komponente enthält und das Ätzen bei einer Temperatur zwischen -40 °C und +50 °C ausgeführt wird.

**3.** Prozeß nach Anspruch 2, bei dem zum Bewirken, daß ein geätzter Seitenwandabschnitt der Masse einen Neigungswinkel $\theta \pm 5°$ hat, die Masse während des Ätzens auf einer Temperatur gehalten wird, die gemäß der folgenden Formel gewählt wird:

$$\theta = \frac{t}{2} + 65$$

wobei t die Temperatur der Masse in Grad Celsius ist.

4. Prozeß nach Anspruch 1, 2 oder 3, bei dem die Masse aus polykristallinem Silizium ist.

5. Prozeß nach irgendeinem vorhergehenden Anspruch, bei dem die Ätzmaske aus einem nichtkohlenstoffhaltigen Material gebildet ist.

6. Prozeß nach Anspruch 4, bei dem die Ätzmaske aus Siliziumoxid oder -nitrid ist.

7. Prozeß nach Anspruch 1 oder Anspruch 3, 4, 5 oder 6, nicht in Verbindung mit Anspruch 2, bei dem das Ätzgas einen Kohlenstoffgehalt von unter 40 ppm Kohlenstoff auf der Basis des Gesamtgewichtes des Ätzgases hat.

8. Prozeß nach Anspruch 1, bei dem das Ätzgas keine kohlenstoffhaltige Verbindung enthält und die Masse aus p-Typ-Silizium oder undotiertem Silizium gebildet ist und während des Ätzens auf einer Temperatur gehalten wird, die größer als +150 °C ist, um zu bewirken, daß ein geätzter Seitenwandabschnitt der Masse längs einer Peripherie der Ätzmaske einen Neigungswinkel (θ) von über 90° hat.

9. Prozeß nach Anspruch 3 oder irgendeinem der Ansprüche 4 bis 8 in Verbindung mit Anspruch 3, bei dem das Ätzgas nur Bromwasserstoff als Reaktionskomponente und ferner ein Edelgas enthält.

10. Prozeß nach Anspruch 3 oder irgendeinem der Ansprüche 4 bis 8 in Verbindung mit Anspruch 3, bei dem das Ätzgas nur Brom als Reaktionskomponente und ferner ein Edelgas enthält.

**Revendications**

1. Procédé pour graver sélectivement une masse de silicium, comprenant :

   la disposition sur la masse d'un masque de gravure définissant des zones explosées de la masse qui doivent être gravées ; et
   la disposition d'un plasma d'un gaz de gravure en contact avec les zones exposées de ladite masse dans une chambre de gravure ;

   caractérisé en ce que ladite chambre de gravure n'a pas de matériau carboné en contact avec ledit plasma du gaz de gravure et en ce que ledit gaz de gravure contient du bromure d'hydrogène, du brome ou une de leurs combinaisons à titre de composant réactif principal qui réagit avec ladite masse et a une teneur en carbone inférieure à 120 ppm de carbone par rapport au poids total dudit gaz de gravure.

2. Procédé selon la revendication 1, dans lequel ledit gaz de gravure ne comprend aucun composant carboné et la gravure est réalisée à une température de -40°C à +50°C.

3. Procédé selon la revendication 2, dans lequel, afin de faire en sorte qu'une partie de paroi latérale gravée de la masse ait un angle d'inclinaison $\theta \pm 5°$, ladite masse est maintenue durant ladite gravure à une température choisie conformément à la formule suivante :

$$\theta = \frac{t}{2} + 65$$

   où t est la température de la masse, en degrés Celsius.

4. Procédé selon la revendication 1, 2 ou 3, dans lequel ladite masse est faite en un silicium polycristallin.

5. Procédé selon l'une quelconque des revendications précédentes, dans lequel ledit masque de gravure est composé d'un matériau ne contenant pas de carbone.

6. Procédé selon la revendication 4, dans lequel ledit masque de gravure est fait d'oxyde ou de nitrure de silicium.

7. Procédé selon la revendication 1, 3, 4, 5 ou 6, lorsqu'elle ne se rapporte pas à la revendication 2, dans lequel ledit gaz de gravure a une teneur en carbone inférieure à 40 ppm de carbone par rapport au poids total dudit gaz de gravure.

**8.** Procédé selon la revendication 1, dans lequel ledit gaz de gravure ne contient aucun composé carboné et ladite masse est formée d'un silicium du type p ou de silicium non dopé et est maintenue à une température supérieure à +150°C durant ladite gravure pour faire en sorte qu'une partie de paroi latérale gravée de la masse, le long d'une périphérie dudit masque de gravure, ait un angle d'inclinaison (0) supérieur à 90°.

**9.** Procédé selon la revendication 3 ou l'une quelconque des revendications 4 à 8 lorsqu'elles se rapportent à la revendication 3, dans lequel ledit gaz de gravure contient uniquement du bromure d'hydrogène à titre de composant réactif et contient en outre un gaz inerte.

**10.** Procédé selon la revendication 3 ou l'une quelconque des revendications 4 à 8 lorsqu'elles se rapportent à la revendication 3, dans lequel ledit gaz de gravure contient uniquement du brome à titre de composant réactif et contient en outre un gaz inerte.

Fig. 1A

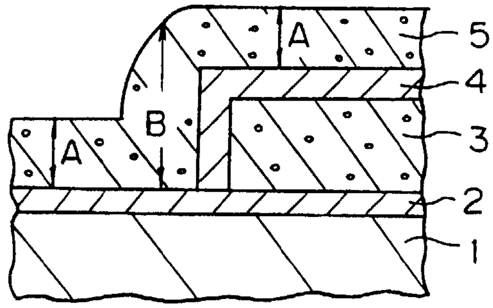


Fig. 1B

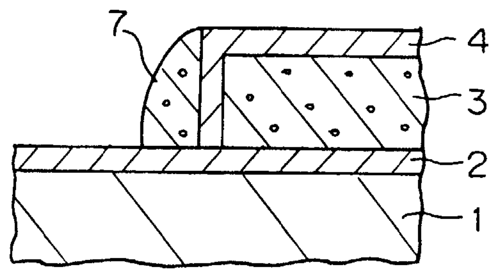


Fig. 1C

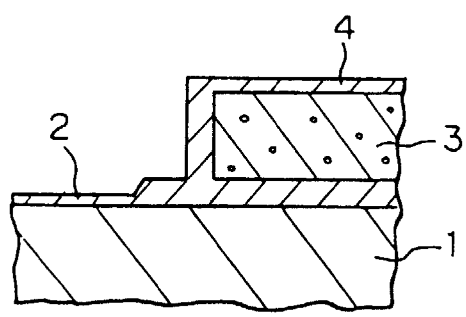

Fig. 2

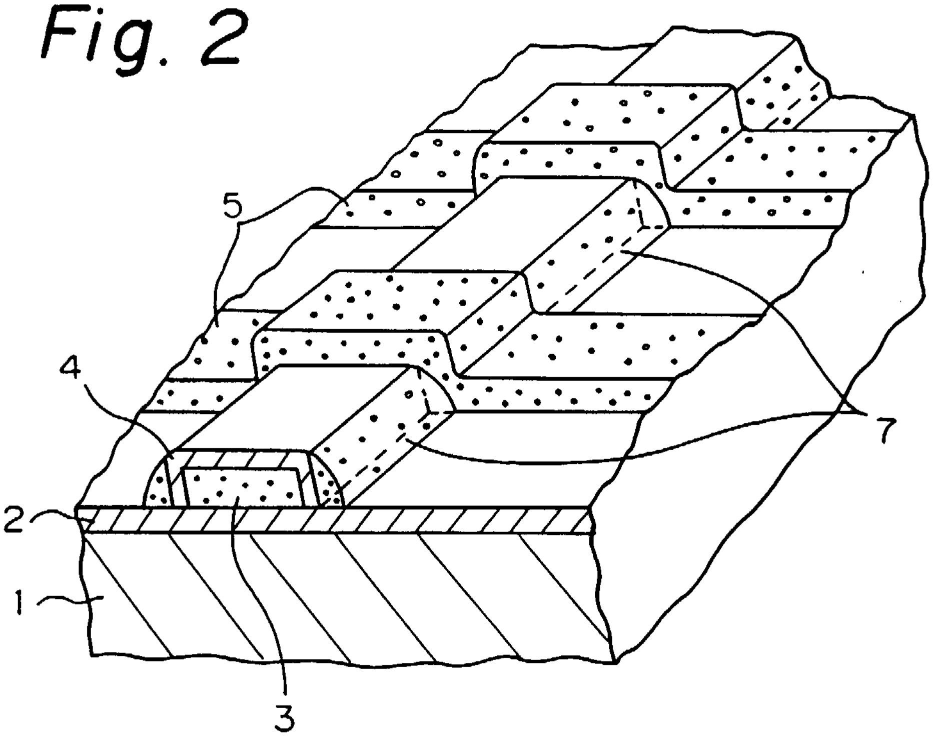


Fig. 3

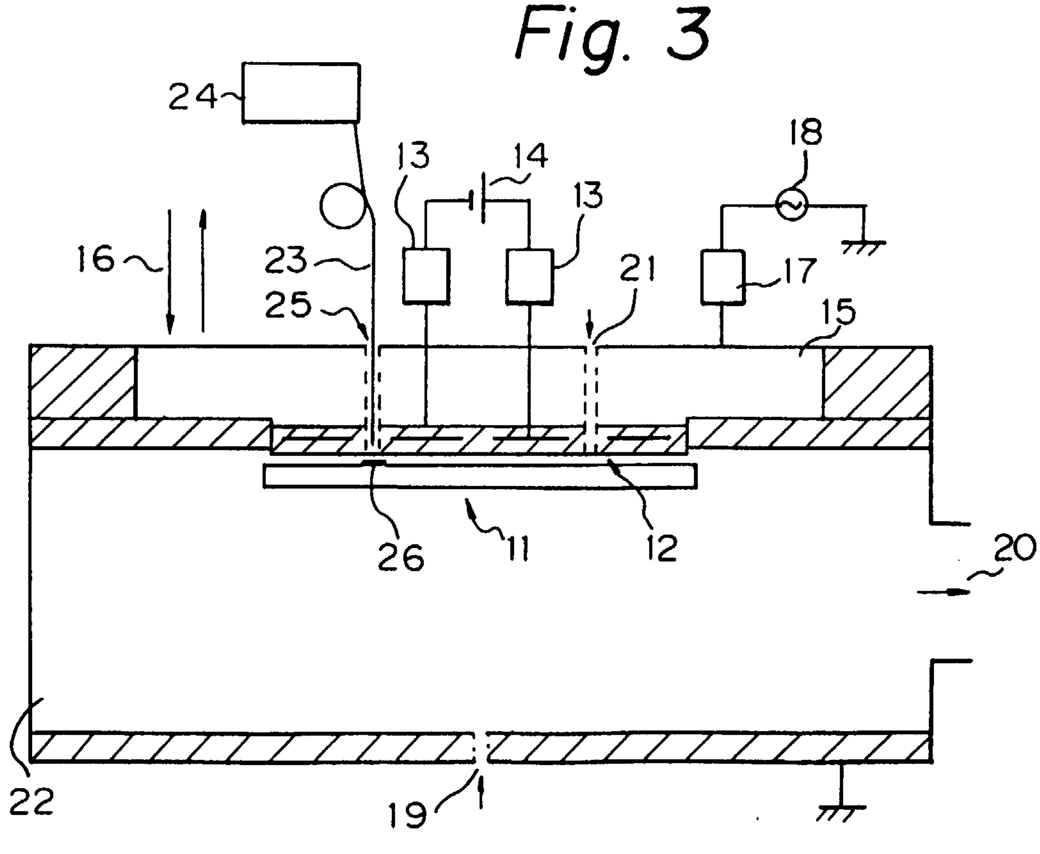

Fig. 4A

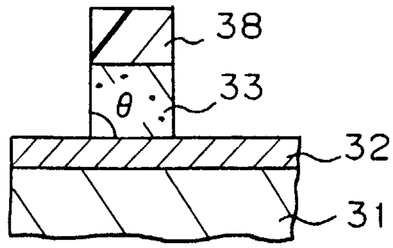


Fig. 4B

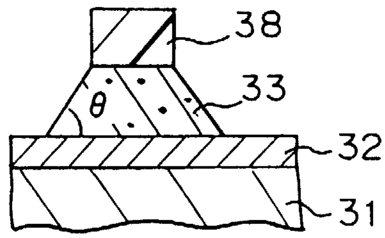


Fig. 4C

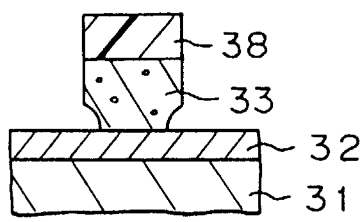


Fig. 4D

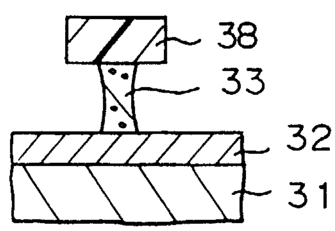


Fig. 4E

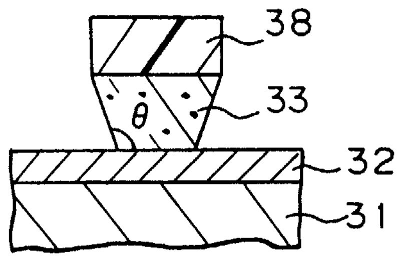

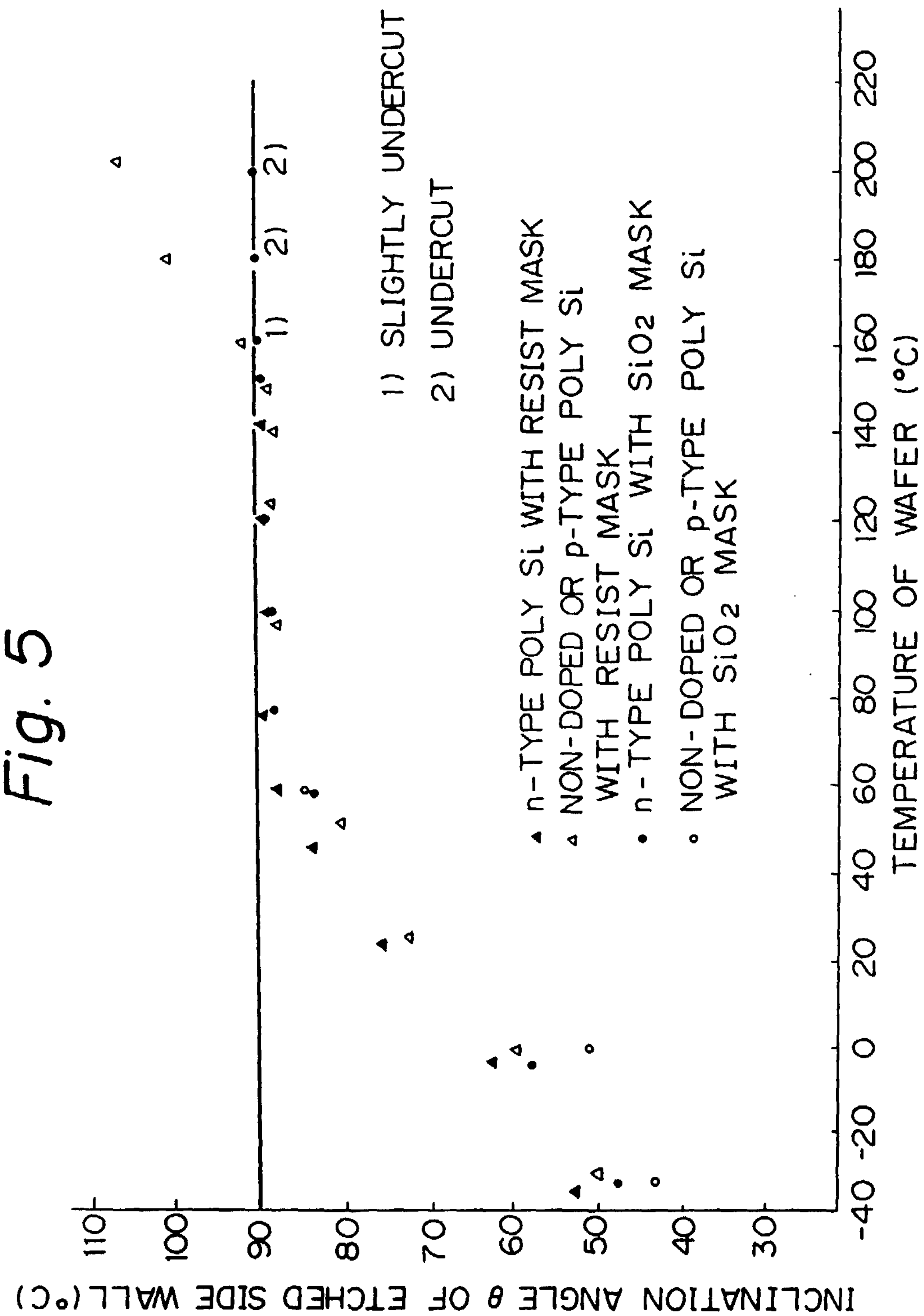
INCLINATION ANGLE θ OF ETCHED SIDE WALL (°C)
110
100
90
80
70
60
50
40
30
-40
-20
0
20
40
60
80
100
120
140
160
180
200
220
TEMPERATURE OF WAFER (°C)
1)
2)
2)
2)
1) SLIGHTLY UNDERCUT
2) UNDERCUT
▲ n-TYPE POLY Si WITH RESIST MASK
△ NON-DOPED OR p-TYPE POLY Si WITH RESIST MASK
• n-TYPE POLY Si WITH SiO2 MASK
∘ NON-DOPED OR p-TYPE POLY Si WITH SiO2 MASK

Fig. 5

# Fig. 6

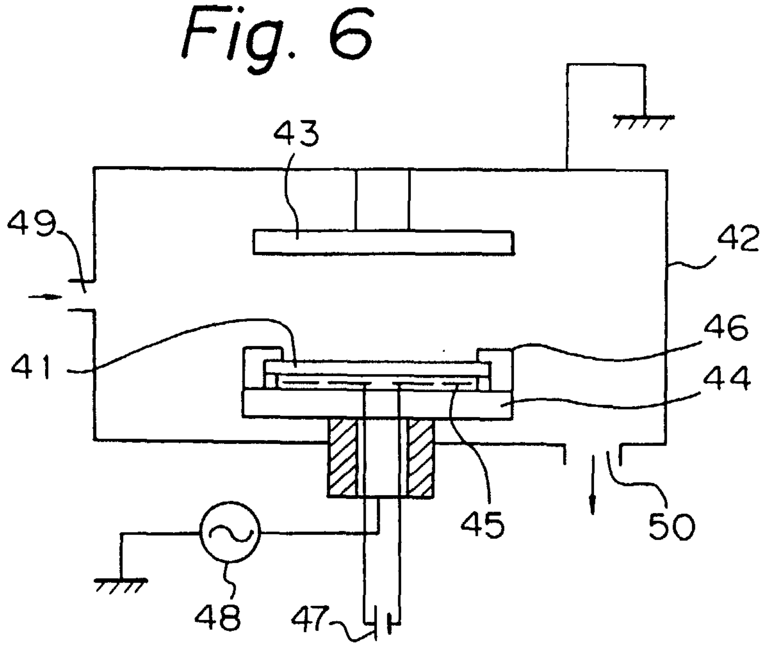
43
49
42
46
41
44
45
50
48
47

# Fig. 7

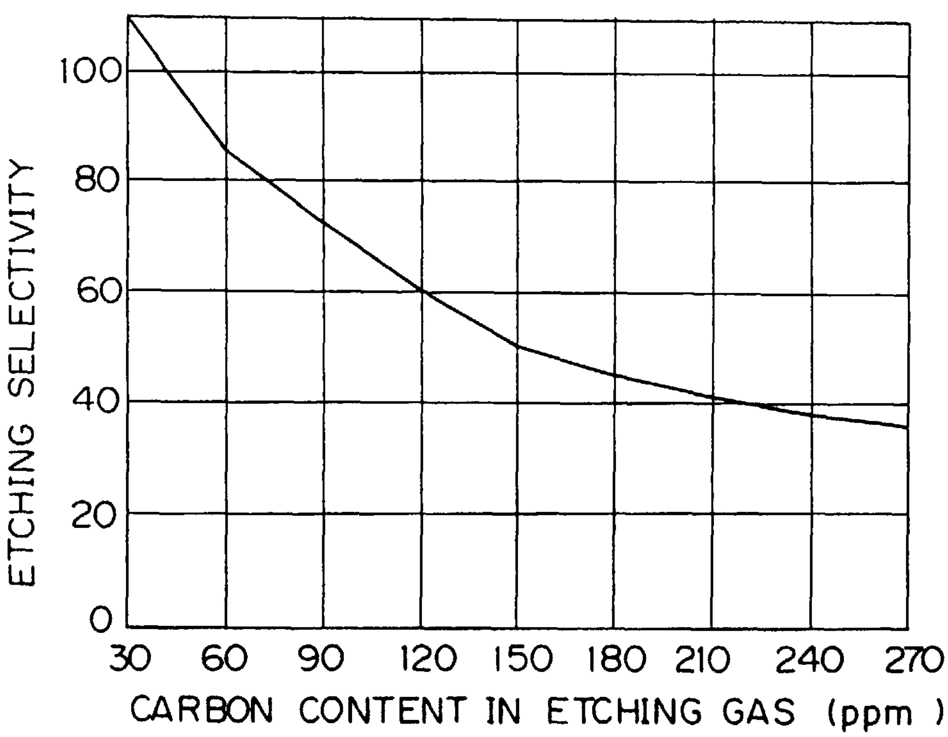
ETCHING SELECTIVITY
100
80
60
40
20
0
30
60
90
120
150
180
210
240
270
CARBON CONTENT IN ETCHING GAS (ppm )